(19) Europäisches Patentamt
European Patent Office
Office européen des brevets

(11)     EP 2 797 236 B1

(12)     **EUROPÄISCHE PATENTSCHRIFT**

(45) Veröffentlichungstag und Bekanntmachung des Hinweises auf die Patenterteilung:
**22.08.2018   Patentblatt 2018/34**

(51) Int Cl.:
**H03M 3/02** *(2006.01)*          **H03M 3/04** *(2006.01)*

(21) Anmeldenummer: **14001368.1**

(22) Anmeldetag: **15.04.2014**

(54) **Zeitkontinuierlicher Delta-Sigma-Modulator**

Continuous-time delta sigma modulator

Modulateur sigma-delta à temps continu

| | |
|---|---|
| (84) Benannte Vertragsstaaten:<br>**AL AT BE BG CH CY CZ DE DK EE ES FI FR GB GR HR HU IE IS IT LI LT LU LV MC MK MT NL NO PL PT RO RS SE SI SK SM TR** | (74) Vertreter: **Koch Müller**<br>**Patentanwaltsgesellschaft mbH**<br>**Maaßstraße 32/1**<br>**69123 Heidelberg (DE)** |
| (30) Priorität: **24.04.2013   DE 102013007030** | (56) Entgegenhaltungen:<br>**EP-A1- 2 056 461     EP-A2- 1 394 950** |
| (43) Veröffentlichungstag der Anmeldung:<br>**29.10.2014   Patentblatt 2014/44** | • **PIETER CROMBEZ ET AL: "A single bit 6.8mW 10MHz power-optimized continuous-time [Delta][Sigma] with 67dB DR in 90nm CMOS", ESSCIRC, 2009. ESSCIRC '09. PROCEEDINGS OF, IEEE, PISCATAWAY, NJ, USA, 14. September 2009 (2009-09-14), Seiten 336-339, XP031563430, ISBN: 978-1-4244-4354-3** |
| (73) Patentinhaber: **TDK-Micronas GmbH**<br>**79108 Freiburg (DE)** | |
| (72) Erfinder: **Muthers, David**<br>**79211 Denzlingen (DE)** | |

EP 2 797 236 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Aus "A 20mW 640-MHz CMOS Continuous-Time $\Sigma\Delta$ ADC With 20-MHz Signal Bandwidth, 80-dB Dynamic Range and 12bit ENOB", Mitteregger et al., IEEE JOURNAL OF SOLID_STATE CIRCUITS, VOL. 41, NO. 12, Dezember 2006, ist ein zeitkontinuierlicher Delta-Sigma-Analog-Digital-Umsetzer bekannt. Zur Eliminierung der Einflüsse auf die Schleifenstabilität werden die Schleifenkondensatoren getrimmt, entweder statisch oder auch im Betrieb. Dazu muss der passende diskrete Kondensatorwert ermittelt werden. Gegenüber einer statischen Trimmung kann nur eine dynamische Trimmung bei nicht-aktivem Modulator Temperatureinflüsse auf Widerstände und Taktfrequenz (fclk) eliminieren. Eine dynamische Trimmung bei aktivem Modulator kann kurzzeitig zu Wandlerfehlern führen.

Aus Pieter Crombetz et al: "A single bit 6.8 mW 10 MHz power-optimized continuous-time DeltaSigma with 67dB DR in 90 nm CMOS", ESSCIRC, 2009, ESSCIRC '09, Proceedings of, IEEE, Piscataway, NJ, USA, 14 September 2009, Seiten 336-339, ISBN: 978-1-4244-4354-3 ist ein zeitkontinuierlicher Delta Sigma Wandler mit einer Schwellspannungseinstellung bekannt. Ferner sind aus der EP 1 394 950 A2 und der EP 2 056 461 A1 weitere Wandler bekannt.

In der DE 10 2008 020 452 A1 werden zusammengesetzte Halbleiterbauteile in einem Feld aus identischen (Halbleiter-)Elementen erzeugt, die auf einem Wafer um einen gemeinsamen Schwerpunkt herum verteilt angeordnet sind, um mögliche Gradienten von Inhomogenitäten von Prozessparametern (Schichtdicken, Dotierung etc.) auszugleichen, die sich durch Prozesstoleranzen entlang der Oberfläche ergeben. Die einzelnen Elemente werden relativ groß dimensioniert.

Der Erfindung liegt die Aufgabe zu Grunde, einen zeitkontinuierlichen Delta-Sigma-Modulator - insbesondere als Bestandteil eines Analog-Digital-Umsetzers - möglichst zu verbessern.

Diese Aufgabe wird durch einen zeitkontinuierlichen Delta-Sigma-Modulator mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist ein zeitkontinuierlicher Delta-Sigma-Modulator vorgesehen.

Der zeitkontinuierliche Delta-Sigma-Modulator weist einen Integrator und einen mit einer Taktfrequenz mittels Taktsignal getakteten Komparator auf. Der Integrator und der Komparator sind in einer Rückkopplungsschleife verbunden.

Der zeitkontinuierliche Delta-Sigma-Modulator weist eine Spannungsquelle auf. Die Spannungsquelle ist mit dem Komparator zum Anlegen einer Schwellspannung an den Komparator verbunden.

Eine Integrationszeitkonstante des Integrators weist einen ersten Widerstand und eine erste Kapazität auf.

Die Spannungsquelle weist einen zweiten Widerstand und eine zweite Kapazität zur Einstellung der Schwellspannung auf.

Der erste Widerstand und der zweite Widerstand sind Bestandteil einer Widerstandspaarungsstruktur.

Die erste Kapazität und die zweite Kapazität sind Bestandteil einer Kapazitätspaarungsstruktur.

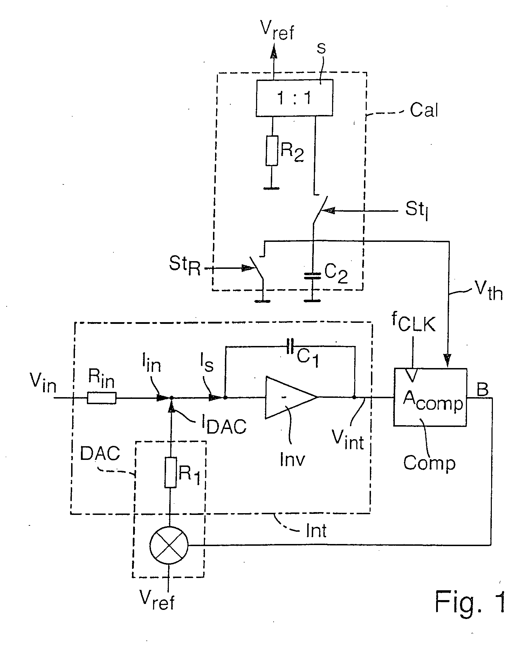

Untersuchungen der Anmelderin haben gezeigt, dass die Widerstandspaarungsstruktur auf einem Halbleiterchip erzielt werden kann, indem der erste Widerstand und der zweite Widerstand durch die gleichen Prozessschritte hergestellt werden. Vorzugsweise sind der erste Widerstand und der zweite Widerstand auf dem Halbleiterchip elektrisch isoliert aneinander angrenzend angeordnet. Weiterhin kann die Kapazitätspaarungsstruktur auf dem Halbleiterchip erzielt werden, indem die erste Kapazität und die zweite Kapazität durch die gleichen Prozessschritte hergestellt werden. Vorzugsweise sind die erste Kapazität und der zweite Kapazität auf dem Halbleiterchip elektrisch isoliert aneinander angrenzend angeordnet. Durch eine konkrete Implementierung des Gegenstands des Anspruchs 1, wie diese beispielsweise im Ausführungsbeispiel der Figur 1 erläutert ist, werden mehrere Vorteile erzielt. Die Stabilität der Schleifenverstärkung des zeitkontinuierlichen Delta-Sigma-Modulators wird für einen großen Bereich der Taktfrequenz erzielt. Weiterhin ist kein Messvorgang und damit verbundene Dimensionierung einer Regelung erforderlich. Die Schwellspannung wird durch die Spannungsquelle nicht geregelt, sondern gesteuert, was eine sehr schnelle Anpassung der Schwellspannung ermöglicht. Einflüsse von Temperaturänderungen und von fertigungsbedingten Abweichungen werden weitgehend reduziert.

Gemäß einer vorteilhaften Weiterbildung ist vorgesehen, dass der Komparator zur Änderung einer Schleifenverstärkung der Rückkopplungsschleife mittels der Schwellspannung ausgebildet ist.

In einer vorteilhaften Weiterbildung ist die Spannungsquelle ausgebildet, die Schwellspannung aus den Eingangsgrößen einer Referenzspannung und einer Periode der Taktfrequenz und aus einer Zeitkonstante zu bilden. Die Zeitkonstante basiert auf dem zweiten Widerstand und der zweiten Kapazität.

Gemäß einer vorteilhaften Weiterbildung weist die am Komparator anliegende Schwellspannung eine umgekehrt proportionale Abhängigkeit von dem Produkt aus dem ersten Widerstand und der ersten Kapazität und der Taktfrequenz auf.

In einer vorteilhaften Weiterbildung weist die Spannungsquelle Halbleiterschalter zur Steuerung eines Entladens der zweiten Kapazität und zur Steuerung eines Ladens der zweiten Kapazität über den zweiten Widerstand für die Dauer einer Periode der Taktfrequenz auf.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen

Fig. 1    einen schematischen Schaltplan eines zeitkontinuierlichen Delta-Sigma-Modulators,

Fig. 2    ein schematisches Diagramm von Steuersignalen, und

Fig. 3    ein schematisches Diagramm einer Übertragungsfunktion.

In zeitkontinuierlichen Delta-Sigma-Modulatoren wird die Schleifenverstärkung durch die Integrationszeitkonstante RC beeinflusst. Die Qualität des so genannten Noise-Shapings und die Stabilität des Modulators hängen vom Verhältnis der Transitfrequenz der Schleifenverstärkung zur Taktfrequenz $f_{clk}$ ab. Durch Fertigungsschwankungen und Temperatureinflüsse können die Integrationszeitkonstante RC und die Taktfrequenz $f_{clk}$ schwanken.

Ziel ist es daher zur kontinuierlichen Stabilisierung dieses Verhältnisses während des normalen Betriebs des Modulators Komparatorschwellen nachzuführen.

Fig. 1 zeigt ein vereinfachtes Modell eines zeitkontinuierlichen Delta-Sigma-Modulators erster Ordnung. Der zeitkontinuierliche Delta-Sigma-Modulator weist einen Integrator Int und einen Komparator Comp und einen Digital-Analog-Umsetzer DAC im Rückkopplungszweig auf. Eine Eingangsspannung $V_{in}$ wird über einen Eingangswiderstand $R_{in}$ in einen Eingangsstrom $I_{in}$ gewandelt. Der Digital-Analog-Umsetzer DAC weist im Ausführungsbeispiel der Fig. 1 ebenfalls einen Widerstand $R_1$ auf, durch den der Ausgangsstrom $I_{DAC}$ des Digital-Analog-Umsetzers DAC fließt. Beide Ströme $I_{in}$ und $I_{DAC}$ werden zum Summenstrom $I_S$ summiert und der Summenstrom $I_S$ durch den invertierenden Verstärker Inv mit Rückkopplung über eine erste Kapazität $C_1$ in die Spannung $V_{int}$ gewandelt. Der Integrator Int bewirkt daher eine Tiefpassfilterung.

Im Folgenden wird die Schleifenstabilität für den zeitkontinuierlichen Delta-Sigma-Modulator erster Ordnung der Fig. 1 erläutert. Die Eingangsspannung $V_{in}$ ist bei der Betrachtung der Schleifenstabilität bedeutungslos. Modulatorschleifen höherer Ordnung lassen sich für Frequenzen um die Transitfrequenz, die für die Stabilitätsbetrachtung entscheidend sind, näherungsweise durch eine Schleife erster Ordnung beschreiben. Aus diesem Grund gilt die nachfolgende Betrachtung auch für Schleifen höherer Ordnung entsprechend.

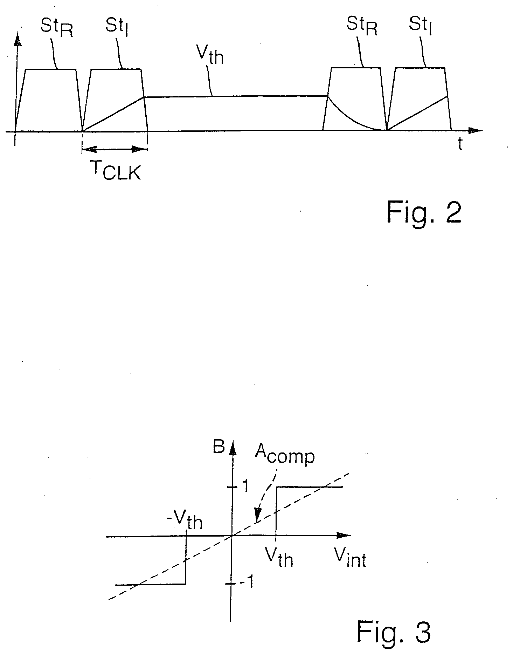

Gemäß dem Ausführungsbeispiel der Fig. 1 ist eine Anwendung für Multibitsysteme vorgesehen. Im Ausführungsbeispiel der Fig. 1 weist der Komparator Comp mehr als zwei Ausgangswerte auf, so dass sich dem Komparator Comp eine Verstärkung $A_{comp}$ zuordnen lässt. Die Verstärkung $A_{comp}$ ist zu Fig. 3 schematisch dargestellt. Der Komparator Comp weist dabei zwei von 0 verschiedene Schwellen auf.

Die Schleifenverstärkung der Rückkoppelschleife in Fig. 1 ist:

$$A_0(j\omega) = \frac{1}{j\omega R_1 C_1} A_{comp} V_{ref} \qquad (1)$$

Dabei ist die Schleifenverstärkung $A_0(j\omega)$ dimensionslos. Die Verstärkung $A_{comp}$ besitzt die Einheit 1/Volt. j ist eine imaginäre Zahl. $\omega$ ist die Kreisfrequenz. $R_1$ ist der erste Widerstand. $C_1$ ist die erste Kapazität. $V_{ref}$ ist eine Referenzspannung. Wie in Fig. 3 dargestellt ist, ist die Verstärkung $A_{comp}$ das Verhältnis eines dimensionslosen Digitalwertes zur Eingangsspannung des Komparators Comp.

Die Verzögerung des Komparators $\Delta T_{comp}$, die bei getakteten Systemen $\alpha T_{clk}$ beträgt, führt zu einer zusätzlichen Phasendrehung in der Rückkoppelschleife gemäß

$$\Delta\varphi_{comp} = 2\pi\Delta T_{comp} f_{T,A0} = 2\pi\frac{\alpha}{f_{clk}} f_{T,A0} \qquad (2)$$

Dabei ist $f_{T,A0}$ die Transitfrequenz der Schleifenverstärkung $A_0(j\omega)$. Die Phasendrehung darf für hinreichende Stabilität maximal 180° betragen. Ein konstantes $\Delta\varphi_{comp}$ führt zu konstanter Phasenreserve und somit zu gleichbleibender Stabilität. Dabei gilt für das Verhältnis:

$$\frac{f_{T,A0}}{f_{clk}} = f_{T,A0}' = \text{kons} \tan t \qquad (3)$$

Die Transitfrequenz $f_{T,A0}$ der Schleifenverstärkung lässt sich ermitteln zu:

$$\left| \frac{A_{comp}V_{ref}}{j2\pi f_{T,A0}R_1C_1} \right| = 1 \qquad (4)$$

$$\rightarrow f_{T,A0} = \frac{A_{comp}V_{ref}}{2\pi R_1 C_1} \qquad (5)$$

Die normierte Transitfrequenz $f_{T,A0}'$ ist dann:

$$f_{T,A0}' = \frac{A_{comp}V_{ref}}{2\pi R_1 C_1 f_{clk}} = \text{kons} \tan t \qquad (6)$$

Somit gilt für die approximierte, linearisierte Verstärkung $A_{comp}$ des Komparators Comp in Fig. 1:

$$A_{comp} \sim R_1 C_1 f_{clk}/V_{ref} \qquad (7)$$

Der Komparator Comp aus Fig. 1 weist eine Übertragungsfunktion auf, die in Fig. 3 schematisch dargestellt ist. Das Ausgangssignal ist -1 für eine Eingangsspannung kleiner $-V_{th}$. Das Ausgangssignal ist 0 für eine Eingangsspannung zwischen $-V_{th}$ und $V_{th}$. Das Ausgangssignal ist 1 für eine Eingangsspannung größer $V_{th}$. Das Ausgangssignal des Komparators Comp ist somit ein ternäres Signal. Alternativ zum Ausführungsbeispiel der Fig. 1 können Komparatoren mit mehr als drei Ausgangszuständen, beispielsweise mit fünf oder sieben Ausgangszuständen verwendet werden.
Die linearisierte Verstärkung $A_{comp}$ dieses Drei-Zustands-Komparators Comp aus Fig. 1 ist in Fig. 3 schematisch dargestellt und lässt sich definieren zu:

$$-> A_{comp} \approx 1/(2V_{th}) \qquad (8)$$

mit der Gleichung (7) wird die Schwellspannung $V_{th}$:

$$-> V_{th} \sim V_{ref}/(R_1 C_1 f_{clk}) \qquad (9)$$

Wenn also die Komparatorschwellen $V_{th}$ eine umgekehrt proportionale Abhängigkeit von dem Produkt aus $R_1$, $C_1$ und $f_{clk}$ besitzen und proportional zur Referenzspannung $V_{ref}$ sind, dann wird die Abhängigkeit der Schleifenstabilität von diesen drei Parametern eliminiert.
In Fig. 1 ist eine mögliche Implementierung einer Spannungsquelle Cal zur Erzeugung der Schwellspannung $V_{th}$ schematisch dargestellt. Dabei wird die Ladung einer Kapazität $C_2$ periodisch gelöscht und mit einem $1/R_2$-proportionalen Strom $I_{ref}$ für die Dauer $T_{clk}$ einer Periode der Taktfrequenz $f_{clk}$ wieder aufgeladen. Zur Erzeugung des Stroms $I_{ref}$ wird beispielsweise der Widerstand $R_2$ und ein Stromspiegel S mit dem Spiegelverhältnis von 1 : 1 an die Spannung $V_{ref}$ angeschlossen. Durch das Steuersignal $St_I$ wird ein zugehöriger Schalter geschlossen und die Kapazität $C_2$ mit dem Strom $I_{ref}$ für die Dauer $T_{clk}$ geladen. Durch das Steuersignal $ST_R$ wird ein zugehöriger Schalter geschlossen und die Kapazität $C_2$ entladen.
Die Spannung $V_{th}$ ergibt sich dann zu:

$$V_{th} = \int_{T_{clk}} \frac{I_{ref}}{C_2} dt = \frac{V_{ref}}{R_2 C_2 f_{clk}} \qquad (10)$$

Fig. 2 zeigt das Diagramm zu Spannungsquelle Cal mit den Steuersignalen $St_I$, $St_R$ aus Fig. 1. In diesem Ausführungsbeispiel wird die Abhängigkeit der Schleifenstabilität von den Parametern eliminiert, indem die Proportionalitätsbeziehung gilt:

$$R_1 C_1 \sim R_2 C_2 \qquad (11)$$

Im einfachsten Fall ist $R_1 = R_2 = R$ und $C_1 = C_2 = C$. Natürlich sind auch andere Verhältnisse möglich. Auch kann die Taktfrequenz z.B. durch Teilung oder Verdopplung geändert werden um die Bedingung gemäß Gleichung (10) zu erfüllen. Ebenfalls ist es möglich zwei unterschiedliche Referenzspannungen, z.B. $V_{ref}$ und $V_{ref}/2$ zu verwenden. Die Widerstände $R_1$ und $R_2$ werden als Paarungsstruktur ausgebildet. Ebenfalls werden die Kapazitäten $C_1$ und $C_2$ als Paarungsstruktur ausgebildet. Ebenfalls ist es möglich, als Widerstandspaarungsstruktur eine Matchingstruktur mit ineinander verschachtelten Widerstandselementen für eine besonders hohe Genauigkeit zu verwenden. Ebenfalls ist es möglich, als Kapazitätspaarungsstruktur eine Matchingstruktur mit ineinander verschachtelten Kapazitätselementen für eine besonders hohe Genauigkeit zu verwenden.

Der zeitkontinuierliche Delta-Sigma-Analog-Digital-Umsetzer des Ausführungsbeispiels der Fig. 1 wird vorteilhafterweise zusammen mit einem Sensor - insbesondere einem Hallsensor - auf einem Halbleiterchip integriert. In einem von der Anmelderin entworfenen Schaltkreis beeinflussen Änderungen der Frequenz $f_{clk}$ von 1/2 des Nominalwertes bis zum 3-fache Nominalwert die Wandlerperformance nicht. Der zeitkontinuierliche Delta-Sigma-Analog-Digital-Umsetzer des Ausführungsbeispiels der Fig. 1 ist sehr robust gegen Absolutwertschwankungen.

Die Erfindung ist nicht auf die dargestellten Ausgestaltungsvarianten der Figuren 1 bis 3 beschränkt. Beispielsweise ist es möglich, eine andere Schaltung zur Erzeugung der Schwellspannung $V_{th}$ anzugeben, die eine entsprechende Abhängigkeit von $T_{clk}$, $R_2$, $C_2$ und $V_{ref}$ hat. Wird ein Komparator mit beispielsweise drei positiven und drei negativen Schwellen verwendet, werden die Schwellspannungen $V_{th}$, $2V_{th}$ und $3V_{th}$ beispielsweise durch in Reihe schalten mehrerer identischer zweiter Kapazitäten erzeugt, die vom Strom $I_{ref}$ gemeinsam geladen und zeitgleich entladen werden. Auch ist es möglich, einen zeitkontinuierlichen Delta-Sigma-Modulator höherer Ordnung vorzusehen, wobei alle Widerstände und Kapazitäten die Proportionalitätsbedingung entsprechend erfüllen.

Bezugszeichenliste

| | |
|---|---|
| R1, R2, $R_{in}$ | Widerstand |
| C1, C2 | Kapazität |
| Inv | invertierende Verstärker |
| Int | Integrator |
| Comp | Komparator |
| DAC | Digital-Analog-Umsetzer |
| Cal | Spannungsquelle |
| S | Stromspiegel |
| | |
| $f_{CLK}$ | Taktfrequenz |
| $T_{CLK}$ | Taktperiode |
| $A_{comp}$ | approximierte Verstärkung |
| $V_{ref}$ | Referenzspannung |
| $V_{int}$ | Integratorausgangsspannung |
| $I_{ref}$ | Referenzstrom |
| $St_I$, $St_R$ | Steuersignal |
| $V_{th}$, $-V_{th}$ | Schwellspannung |
| t | Zeit |
| B | Komparatorausgangssignal |

**Patentansprüche**

1. Zeitkontinuierlicher Delta-Sigma-Modulator,

   - mit einem Integrator (Int) und einem mit einer Taktfrequenz ($f_{clk}$) getakteten Komparator (Comp), die in einer Rückkopplungsschleife verbunden sind,
   - mit einer Spannungsquelle (Cal), die mit dem Komparator (Comp) zum Anlegen einer Schwellspannung ($V_{th}$) an den Komparator (Comp) verbunden ist, und die Spannungsquelle (Cal) eine zweite Kapazität ($C_2$) zur Einstellung der Schwellspannung ($V_{th}$) aufweist,
   - bei dem eine Integrationszeitkonstante des Integrators (Int) einen ersten Widerstand ($R_1$) und eine erste Kapazität ($C_1$) aufweist,

   **dadurch gekennzeichnet, dass**

   - bei dem die Spannungsquelle (Cal) einen zweiten Widerstand ($R_2$) zur Einstellung der Schwellspannung ($V_{th}$) aufweist,
   - bei dem der erste Widerstand ($R_1$) und der zweite Widerstand ($R_2$) Bestandteil einer Widerstandspaarungsstruktur sind, und
   - bei dem die erste Kapazität ($C_1$) und die zweite Kapazität ($C_2$) Bestandteil einer Kapazitätspaarungsstruktur sind.

2. Zeitkontinuierlicher Delta-Sigma-Modulator nach Anspruch 1,

   - bei dem der Komparator (Comp) zur Änderung einer Schleifenverstärkung ($A_0(j\omega)$) der Rückkopplungsschleife mittels der Schwellspannung ($V_{th}$) ausgebildet ist.

3. Zeitkontinuierlicher Delta-Sigma-Modulator nach einem der vorhergehenden Ansprüche,

   - bei dem die Spannungsquelle (Cal) ausgebildet ist, die Schwellspannung ($V_{th}$) aus den Eingangsgrößen einer Referenzspannung ($V_{ref}$) und einer Periode ($T_{clk}$) der Taktfrequenz ($f_{clk}$) und aus einer Zeitkonstante zu bilden, wobei die Zeitkonstante auf dem zweiten Widerstand ($R_2$) und der zweiten Kapazität ($C_2$) basiert.

4. Zeitkontinuierlicher Delta-Sigma-Modulator nach einem der vorhergehenden Ansprüche,

   - bei dem die Schwellspannung ($V_{th}$) eine umgekehrt proportionale Abhängigkeit von dem Produkt aus dem ersten Widerstand ($R_1$) und der ersten Kapazität ($C_1$) und der Taktfrequenz ($f_{clk}$) aufweist.

5. Zeitkontinuierlicher Delta-Sigma-Modulator nach einem der vorhergehenden Ansprüche,

   - bei dem die Spannungsquelle (Cal) Halbleiterschalter zur Steuerung eines Entladens der zweiten Kapazität ($C_2$) und zur Steuerung eines Ladens der zweiten Kapazität ($C_2$) über den zweiten Widerstand ($R_2$) für die Dauer einer Periode ($T_{clk}$) der Taktfrequenz ($f_{clk}$) aufweist.

6. Zeitkontinuierlicher Delta-Sigma-Modulator nach einem der vorhergehenden Ansprüche,

   - bei dem die Rückkopplungsschleife weitere Integratoren zur Ausbildung des Delta-Sigma-Modulators einer Ordnung größer eins aufweist.

**Claims**

1. Continuous-time delta sigma modulator,

   - with an integrator (Int) and a comparator (Comp) which is cycled at a clock frequency ($f_{clk}$) and which is connected into a feedback loop, and
   - with a voltage source (Cal), which is connected with the comparator (Comp) for application of a threshold voltage ($V_{th}$) to the comparator (Comp) and which comprises a second capacitance ($C_2$) for setting the threshold voltage ($V_{th}$),

- in which an integration time constant of the integrator (Int) has a first resistance ($R_1$) and a first capacitance ($C_1$),

**characterised in that**

- in which the voltage source (Cal) has a second resistance ($R_2$) for setting the threshold voltage ($V_{th}$),
- in which the first resistance ($R_1$) and the second resistance ($R_2$) are a component of a resistance pairing structure and
- in which the first capacitance ($C_1$) and the second capacitance ($C_2$) are a component of a capacitance pairing structure.

2. Continuous-time delta sigma modulator according to claim 1,

- in which the comparator (Comp) is configured for changing a loop amplification ($A_0(j\omega)$) of the feedback loop by means of the threshold voltage ($V_{th}$).

3. Continuous-time delta sigma modulator according to one of the preceding claims,

- in which the voltage source (Cal) is constructed for forming the threshold voltage ($V_{th}$) from the input variables of a reference voltage ($V_{ref}$) and a period ($T_{clk}$) of the clock frequency ($F_{clk}$) and from a time constant, wherein the time constant is based on the second resistance ($R_2$) and the second capacitance ($C_2$).

4. Continuous-time delta sigma modulator according to any one of the preceding claims,

- in which the threshold voltage ($V_{th}$) has an inversely proportional dependence on the product of the first resistance ($R_1$) and the first capacitance ($C_1$) and the clock frequency ($f_{clk}$).

5. Continuous-time delta sigma modulator according to any one of the preceding claims,

- in which the voltage source (Cal) comprises semiconductor switches for controlling discharging of the second capacitance ($C_2$) and for controlling charging of the second capacitance ($C_2$) by way of the second resistance ($R_2$) for the duration of a period ($T_{clk}$) of the clock frequency ($f_{clk}$).

6. Continuous-time delta sigma modulator according to any one of the preceding claims,

- in which the feedback loop comprises further integrators for constructing the delta sigma modulator of an order greater than one.

**Revendications**

1. Modulateur sigma-delta à temps continu,

- avec un intégrateur (Int) et un comparateur (Comp) synchronisé avec une fréquence d'horloge ($f_{clk}$), qui sont reliés dans une boucle de rétroaction,
- avec une source de tension (Cal), qui est reliée au comparateur (Comp) pour appliquer une tension de seuil ($V_{th}$) au comparateur (Comp), et la source de tension (Cal) présente une deuxième capacité ($C_2$) pour le réglage de la tension de seuil ($V_{th}$),
- dans lequel une constante de temps d'intégration de l'intégrateur (Int) présente une première résistance ($R_1$) et une première capacité ($C_1$),

**caractérisé en ce que**

- la source de tension (Cal) présente une deuxième résistance ($R_2$) pour le réglage de la tension de seuil ($V_{th}$),
- la première résistance ($R_1$) et la deuxième résistance ($R_2$) font partie d'une structure d'appariement de résistances et
- la première capacité ($C_1$) et la deuxième capacité ($C_2$) font partie d'une structure d'appariement de capacités.

2. Modulateur sigma-delta selon la revendication 1,

- dans lequel le comparateur (Comp) est configuré pour le changement d'une amplification de boucle ($A_0(j\omega)$) de la boucle de rétroaction au moyen de la tension de seuil ($V_{th}$).

3. Modulateur sigma-delta à temps continu selon l'une quelconque des revendications précédentes,

- dans lequel la source de tension (Cal) est configurée pour former la tension de seuil ($V_{th}$) à partir des grandeurs d'entrée d'une tension de référence ($V_{ref}$) et d'une période ($T_{clk}$) de la fréquence d'horloge ($f_{clk}$) et à partir d'une constante de temps, dans lequel la constante de temps est basée sur la deuxième résistance ($R_2$) et la deuxième capacité ($C_2$).

4. Modulateur sigma-delta à temps continu selon l'une quelconque des revendications précédentes,

- dans lequel la tension de seuil ($V_{th}$) présente une dépendance inversement proportionnelle au produit de la première résistance ($R_1$) et de la première capacité ($C_1$) et de la fréquence d'horloge ($f_{clk}$).

5. Modulateur sigma-delta à temps continu selon l'une quelconque des revendications précédentes,

- dans lequel la source de tension (Cal) présente des commutateurs à semi-conducteur pour la commande d'une décharge de la deuxième capacité ($C_2$) et pour la commande d'une charge de la deuxième capacité ($C_2$) via la deuxième résistance ($R_2$) pour la durée d'une période ($T_{clk}$) de la fréquence d'horloge ($f_{clk}$).

6. Modulateur sigma-delta à temps continu selon l'une quelconque des revendications précédentes,

- dans lequel la boucle de rétroaction présente d'autres intégrateurs pour la configuration du modulateur sigma-delta d'un ordre supérieur à un.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1394950 A2
- EP 2056461 A1
- DE 102008020452 A1

**In der Beschreibung aufgeführte Nicht-Patentliteratur**

- **MITTEREGGER et al.** A 20mW 640-MHz CMOS Continuous-Time $\Sigma\Delta$ ADC With 20-MHz Signal Bandwidth, 80-dB Dynamic Range and 12bit ENOB. *IEEE JOURNAL OF SOLID_STATE CIRCUITS,* Dezember 2006, vol. 41 (12
- A single bit 6.8 mW 10 MHz power-optimized continuous-time DeltaSigma with 67dB DR in 90 nm CMOS'', ESSCIRC. **PIETER CROMBETZ et al.** ESSCIRC '09, Proceedings of. IEEE, 14. September 2009, 336-339